# EUROPEAN PATENT APPLICATION

(11) **EP 1 521 301 A1**
(43) Date of publication of application: **06.04.2005**
(21) Application number: 03447239.9
(22) Date of filing: 30.09.2003
(51) Int. Cl.: H01L 21/768

(54) **Method of formation of airgaps around interconnecting line**

(71) Applicant: Interuniversitaire Microelectronica Centrum vzw ( IMEC), 3001 Leuven (BE)
(72) Inventor: Gueneau de Mussy, Jean-Paul, 1050 Elsene (BE); Maex, Karen, 3020 Herent (BE); Beyer, Gerald, 3001 Leuven (BE)
(74) Representative: Van Malderen, Joelle

(57) **Abstract**

Method for the production of air gaps (4) in a semiconductor device comprising a stack of layers comprising at least one iteration of a sub-stack of layers comprising:
- a first dielectric layer (2) made e.g. of SiC, a second dielectric layer (3) made e.g. of SiO₂ under the first dielectric layer (2);
wherein
- the first dielectric is resistant to a first etching substance able to etch the second dielectric;
the method comprising the steps of
a) etching a hole in the stack of layers with a second etching substance;
b) chemically changing the properties of the first dielectric (2) locally, whereby part of the first dielectric (2) is converted locally and becomes etchable by the first etching substance e.g. by changing SiC into SiO₂ by an O₂ plasma treatment;
c) filling the hole with a conductive material (1), optionally separated from the second dielectric (3) by a barrier layer, the conductive material (1) and, if present, the barrier layer being resistant to the first etching substance;
d) applying the first etching substance to the stack of layers whereby air gaps (4) are created around the conductive material (1).

## Description

### Field of the invention

The present invention is related to the field of semiconductor processing. More specifically it is related to the production of micro and nano-electromechanical systems (MEMS, NEMS) and to the production of low dielectric isolation for interconnects. It contributes to the exploration of the field of airgaps integration in semiconductor devices.

### Background of the invention

The use of airgaps in semiconductor devices is known. Airgaps in the form of cavities can typically be present in MEMS and NEMS devices. Those airgaps can structurally be part of such a device or can have a functional role.
Airgaps are considered to be very promising in the technology of interconnects, where they can be used as dielectric for isolation of interconnects. As IC technology scales down, the interconnect is becoming the most important restricting factor in terms of propagation delay, dynamic power consumption and signal errors originated by cross-talk effects between adjacent metal lines. The refocus from aluminium to copper has given an important reduction in the resistance of wired connections on the chip. At the moment, the aim is to achieve better isolation between the lines by introducing materials with lower dielectric constant than that of silicon oxide (k=4.2) leading to reducing the capacitance (C). The integration of low-k materials (k<3.0) into production processes creates a number of challenges associated with leakage, mechanical instability and joule heating, increasing the overall cost of future IC processes. Additionally, the barrier and intermediate layers tend to increase the effective permittivity of the final stack. Due to the aforementioned problems, and also because air is the best insulator available, a strong incentive exists to integrating airgaps between adjacent metal lines.
The use of air as a dielectric to isolate electrical interconnects is known to reduce RC delay as well as dynamic power consumption and signal errors (e.g. cross-talk).

Different ways of inducing air cavities are known in the art, for instance;
(i) Isotropic Etching (for MEMS applications): consists of using HF for dissolving a sacrificial SiO2 layer, where other non-reacting film (i.e. SiC) is employed as an etch stop. The etch source is then sealed by a non-conformal CVD SiO2 layer.
(ii) Anisotropic Etching: this consists of eliminating material by anisotropic dry etch, it is then necessary having a dedicated mask and adding the subsequent dry etch and strip operations. Subsequently a conformal CVD SiO2 followed by a non-conformal CVD SiO2 film are deposited on top of the lines responsible for the creation of airgaps.

In US 6,268,261 a process for manufacturing a semiconductor circuit comprising airgaps is disclosed. The process comprises the steps of creating a plurality of adjacent conductive lines having a solid fill between the conductive lines; creating one or more layers above the lines and the fill; creating one or more pathways to the fill through the layers; and converting the fill to a gas that escapes through the pathways, leaving an air void between adjacent lines. The process results in a multi-layer semiconductor circuit comprising conductive lines, wherein the lines have air as a dielectric between them. Here a solid fill needs to be deposited inside between the conductive lines. This fill has to be stable during deposition of the layers on top. In the layers on top a pathway needs to be foreseen, which requires additional processing such as extra masking and etching steps.

In US patent 6,599,814 a method is disclosed for removal of silicon carbide layers and in particular amorphous SiC of a substrate. Initially, the exposed part of a carbide-silicon layer is at least partly converted into an oxide-silicon layer by exposing the carbide-silicon layer to an oxygen containing plasma. The oxide-silicon layer is then removed from the substrate.

### Aim of the invention

It is an aim of the invention to provide a method, which allows to selectively introduce air between narrowly spaced adjacent metal lines. It is further an aim of the present invention to provide such a method, which is substantially scaling invariant. It is also an aim of the present invention to provide a method, which comprises a small number of process steps, compared to other state-of the art methods. More specifically it is an aim of the present invention to provide a process that does not introduce extra masking/stripping steps.

### Summary of the invention

A method for the production of airgaps in a semiconductor device is disclosed, the semiconductor device comprising a stack of layers , the stack of layers comprising at least one iteration of a sub-stack of layers, the sub-stack of layers comprising;
- a liner layer made of liner material;
- a sacrificial layer made of sacrificial layer material under the liner layer;
wherein
- the liner material is resistant to a first etching substance;
- the first etching substance is able to etch the sacrificial layer material;
the method comprising the steps of
a) etching a hole in the stack of layers with a second etching substance,
b) chemically and/or mechanically changing the properties of the liner layers locally, whereby part of the liner layers is converted locally and becomes etchable by the first etching substance.
c) creating in the hole a line made of a conductive material, optionally separated from the sacrificial layer by a barrier layer, theline or, if present, the barrier layer being resistant to the first etching substance;
d) applying the first etching substance to the stack of layers whereby airgaps are created around the line.

The creation of the line in the hole can be performed by any state-of-the-art technique.

Preferably step (c) comprises the sub-steps of:
i. optionally depositing a barrier layer.
ii. depositing on top of the barrier layer a layer of electrically conductive material.
iii. applying a subtractive technique on top of the stack of layers whereby at least 1 embedded line is created.

In case the conducting material of the line is not resistant to the first etching substance and a barrier layer is present, an additional step of depositing a protective layer on the exposed part of the line before step (d) is performed can be preferred.

Preferrably the conductive material is selected from the group of [metals, carbon nanotubes, conducting polymers]
The conductive material can be for example Cu, Au or Ag.

The production of airgaps for electrical isolation purposes is an aim of the present invention, but airgaps can also be created in other contexts as for instance in the context of MEMS devices, where the airgap can be part of structurally or functionally.

In preferred embodiments the steps of etching a hole in the stack of layers, and chemically and/or mechanically changing the properties of the liner layers locally, are performed at the same time.
In preferred embodiments the liner layer material is converted locally into the sacrificial material.
The chemically and/or mechanically changed part of the liner layers has preferably in-plane dimensions smaller than 1 µm, more preferably 500 nm, even more preferably 100 nm. In-plane dimensions of smaller than 10 nm are easily possible.
The stack of layers can be typically a single or dual damascene stack, but is not limited thereto.
In specific embodiments the stack of layers further comprises a basis layer.
Preferably the basis layer is resistant to the second etching substance, this way the etching of the hole in the stack of layers is downwards limited by the basis layer. The basis layer can comprise an embedded metal line.
In certain embodiments according to the present invention, the basis layer is resistant to the first etching substance, which can be downwards limiting the formation of the airgaps.
In preferred embodiment the sacrificial layer material is silicon dioxide (SiO₂).
In preferred embodiment the liner layer material is silicon carbide (SiC).
In preferred embodiment the second etching substance comprises O₂.
In preferred embodiment the first etching substance comprises hydrofluoric acid (HF).
In preferred embodiment the hole is located at the back end of line.
In preferred embodiment the basis layer comprises an embedded metal line.
In preferred embodiment the embedded metal line and the metal line are forming an electrical contact.
In preferred embodiments the method according to the present invention can be repeated. It is shown that on top af an airgap structure new layers can be formed, on which the method according to the present invention can be repeated.

### Short description of the figures

Fig. 1 is a schematic representing a standard Cu single damascene (SD) stack before (a) and after (b) etch of sacrificial material between narrowly spaced interconnects (1). Typical interconnects are metals (ie. Cu, Au, Ag...) embedded in a (3) SiO₂ and (2) SiC stack. (4) Are selectively incorporated airgaps.
Fig. 2 (a) is a schematic representing the starting stack after resist coating and deep ultra violet (DUV) patterning (5). The liner layer (2) can be for example a Si₃N₄ layer, indicated with (6).
Fig. 2 (b) shows the stack (a) after undergoing oxygen containing plasma exposure leading to a local oxidation of the SiC layer (7).
Fig. 2 (c) is the former stack after barrier deposition (ie. Ta/TaN (10/15 nm), Cu seed layer deposition (100 nm), Cu electroplating (1 µm) and chemical mechanical polishing (CMP).
Fig. 2 (d) is after vapour HF (VHF) exposure (8) generating air cavities near the SiO2/TaN interface.
Fig. 2 (e) is after a thick conformal CVD layer (ie. SiC/SiO₂ CVD) has been deposited on top.
Fig. 3 (a) is a schematic representing the starting stack after resist coating and deep ultra violet (DUV) patterning (5). (9) Is a CVD or spin on material resistant to HF exposure (ie. Silicon oxycarbide SiCOH).
Fig. 3 (b) shows the stack (a) after undergoing oxygen containing plasma exposure leading to a local oxidation of the SiC layer (7).
Fig. 3 (c) is the former stack after barrier deposition (i.e. Ta/TaN (10/15 nm), Cu seed layer deposition (100 nm), Cu electroplating (1 µm) and chemical mechanical polishing (CMP).
Fig. 3 (d) is after VHF exposure (8) generating air cavities near the SiO₂/TaN interface. Note that the underlying material is not etched by HF, which is intended to confine the airgap cavities to a single level.
Fig. 3 (e) is after a thick conformal CVD layer (ie. SiC/SiO₂ CVD) has been deposited on top.
Fig. 4i and Fig. 4ii differ in the fact that a line (1) is embedded in the second sacrificial layer. Fig. 4 refers then to Fig. 4i and Fig. 4ii.

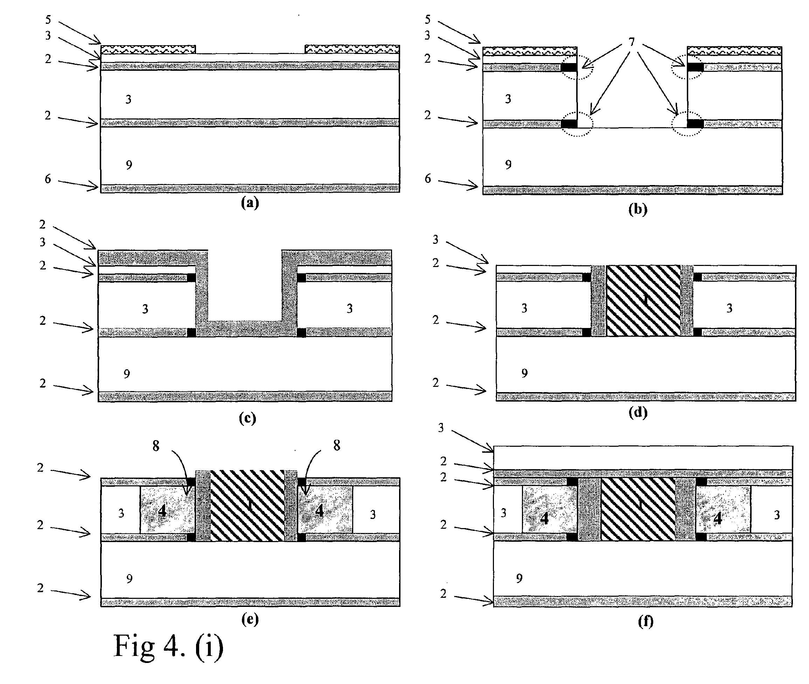

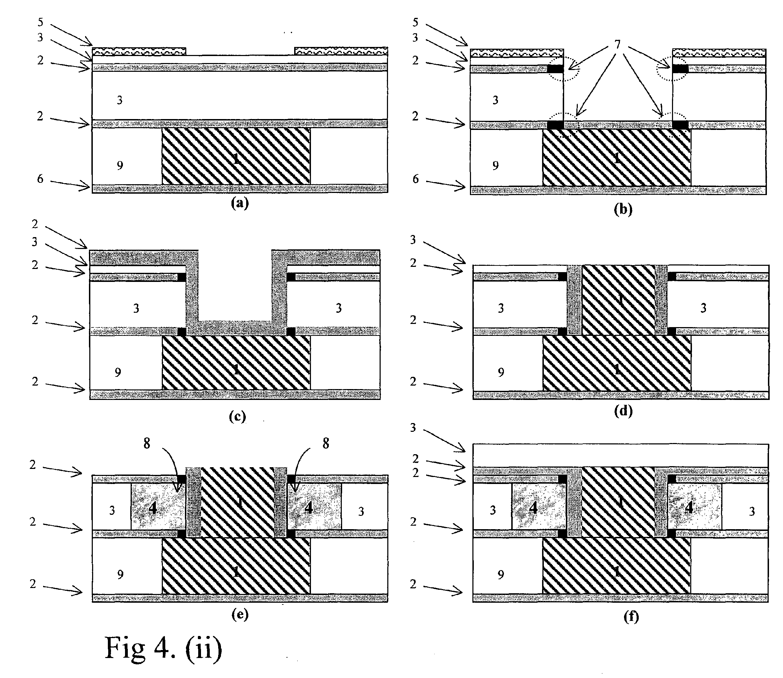

Fig. 4 (a) is a schematic representing the starting stack after resist coating and deep ultra violet (DUV) patterning (5).
Fig. 4 (b) shows the stack (a) after a dry etch operation in an O₂ containing plasma.
Fig. 4 (c) is the former stack after a liner (ie. 50 nm SiC) has been deposited.
Fig. 4 (d) is after an isotropic oxygen plasma treatment with the aim of opening the bottom of the SiC.
Fig. 4 (e) is after deposition of a barrier (ie. Ta/TaN (10/15 nm), Cu seed layer deposition (100 nm) and Cu electroplating (1 µm) followed by (CMP) and HF vapour exposure, generating air cavities (4).
Fig. 4 (f) is after a thick conformal CVD layer (ie. SiC/SiO₂ CVD) has been deposited on top of the air cavities (4).

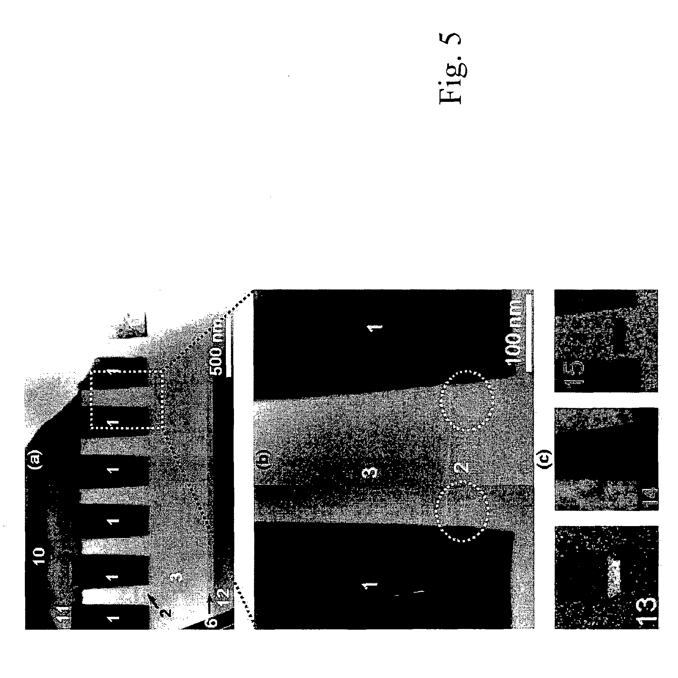

Fig. 5 is a cross-sectional TEM image of the Cu/SiO₂ single damascene stack at low (a) and high (b) magnification, (10) and (11) correspond to a protective platinum and glass layers respectively. 12 refers to the Si substrate. (c) Correspond to C (13), Cu (14) and O (15) EFTEM mappings of the area surrounded by the white dotted square on (a). Note that in EFTEM analysis light zones refer to high element concentrations. The white dotted circles denote converted SiC regions (plugs).

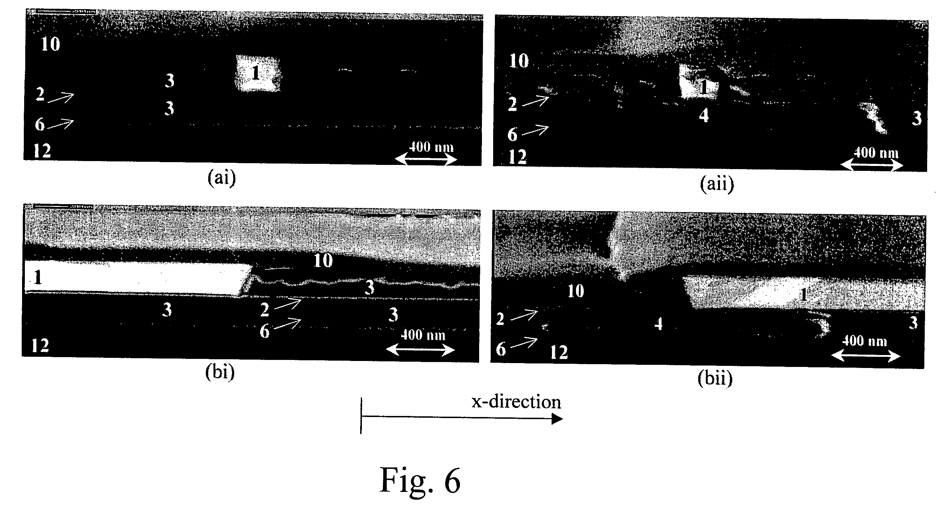

Fig. 6 are cross-sectional FIB images of a standard Cu-SiO₂ single damascene stack after (i) 4 and (ii) 8 minutes of VHF etch. (a) Represents a narrow line (low area), while (b) stands for a bondpad (large area). The x-direction is indicated on the figure.

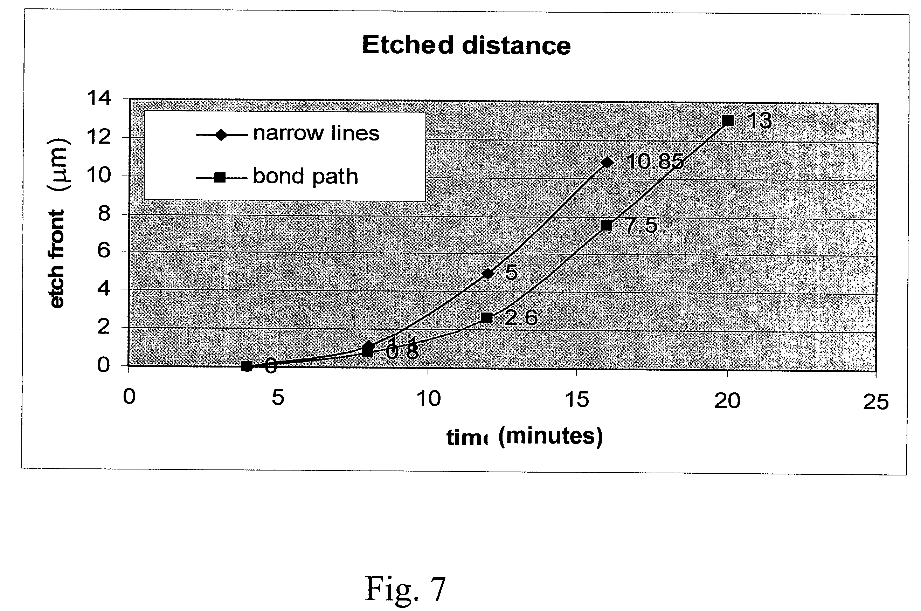

Fig. 7 is a plot showing the etched distance (half of actual groove in x-direction) vs. time dependence of narrow lines and bond paths.

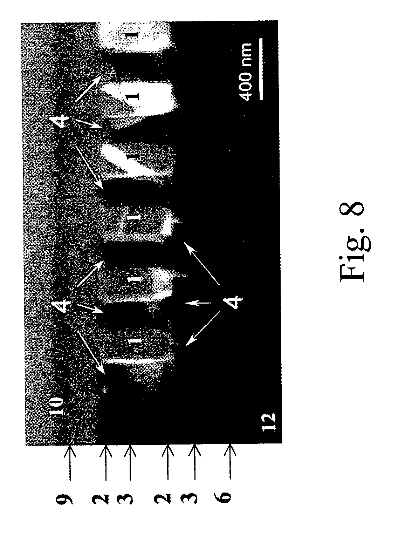

Fig. 8 is a schematic representing the SD stack after an arbitrary VHF exposure time leading to the incorporation of an airgap underneath a Cu line. The preferential channels of HF diffusion are shown by black dots at the SiC / Ta(N) interface.

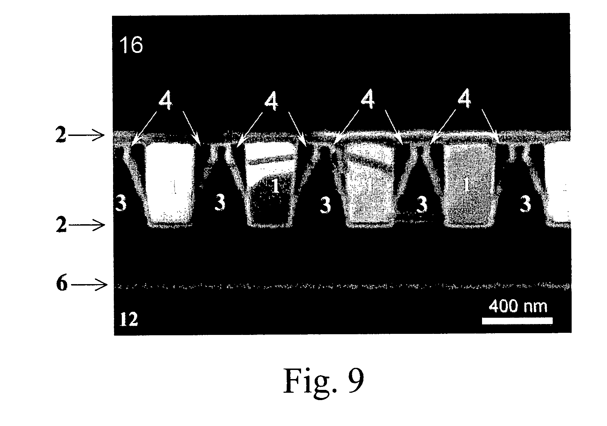

Fig. 9 is a schematic representing the SD stack after an arbitrary VHF exposure time leading to the incorporation of airgaps between narrowly spaced (300 mm) lines. Here (16) refers to a SiC (50 nm) - SiO2 (300 nm) - Si3N4 (500 nm) layer on top of the airgap structure.

### Detailed description of the invention

The following description and examples illustrate preferred embodiments of the present invention in detail. Those of skill in the art will recognize that there are numerous variations and modifications of this invention that are encompassed by its scope. Accordingly, the description of preferred embodiments should not be deemed to limit the scope of the present invention.

A method for the production of airgaps in a semiconductor device is disclosed.

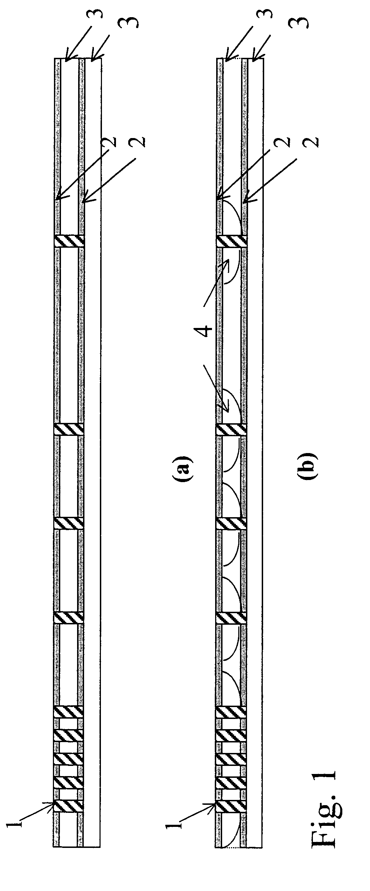

Fig. 1 represents a standard Cu single damascene (SD) stack before (a) and after (b) etch of sacrificial material between narrowly spaced interconnects (1). Typical interconnects are metals (ie. Cu, Au, Ag...) embedded in a (3) dielectric stack which also contains liners (2). The dielectric material and liner are deposited on a Si or other substrate (which is not shown in the Figures) by a method such as Plasma Enhanced Chemical Vapour Deposition (PECVD), Chemical Vapour Deposition (CVD), spin-on deposition etc. Examples of materials (2) and (3) are the Organo Silicate Glass (OSG), which are also commonly referred to as SiOC:H materials or Carbon doped oxides (including higher porosity derivatives), the class of MethylSilsesQuioxane (MSQ). An example for the liner is any carbon containing Si compound such as SiC, SiC:H etc. In Fig. 1 items (4) represent selectively incorporated airgaps.

In preferred embodiments according to the present invention metal lines (1), for instance Cu lines, are embedded in a sacrificial material (3) (i.e. SiO₂). The metal lines (1) are typically further separated from the sacrificial material (3) by a barrier layer (not shown in the figures), as for instance a Ta/Ta(N) barrier. This barrier layer can have a function as diffusion barrier. A liner (hard mask) (2) is deposited on top (for instance SiC), which is resistant to etching agents for the sacrificial layer material (for instance HF) and is preferrably non-conducting. An induced local conversion of the liner, before the creation of the metal line (1), has to be performed (possible at nanometer scale), generating vulnerable spots (plugs). For instance a localised plasma conversion of the SiC liner into SiO₂. The plugs are expected to act as preferential channels for chemicals diffusion. A metal line and typically also a barrier layer is deposited and a dissolution of the sacrificial material follows by applying the etching agent. This takes place preferentially between narrowly spaced Cu lines.

A way to selectively introduce air between narrowly spaced Cu interconnects in a single step is disclosed being fully compatible with the back end of line process as illustrated in Fig. 1.

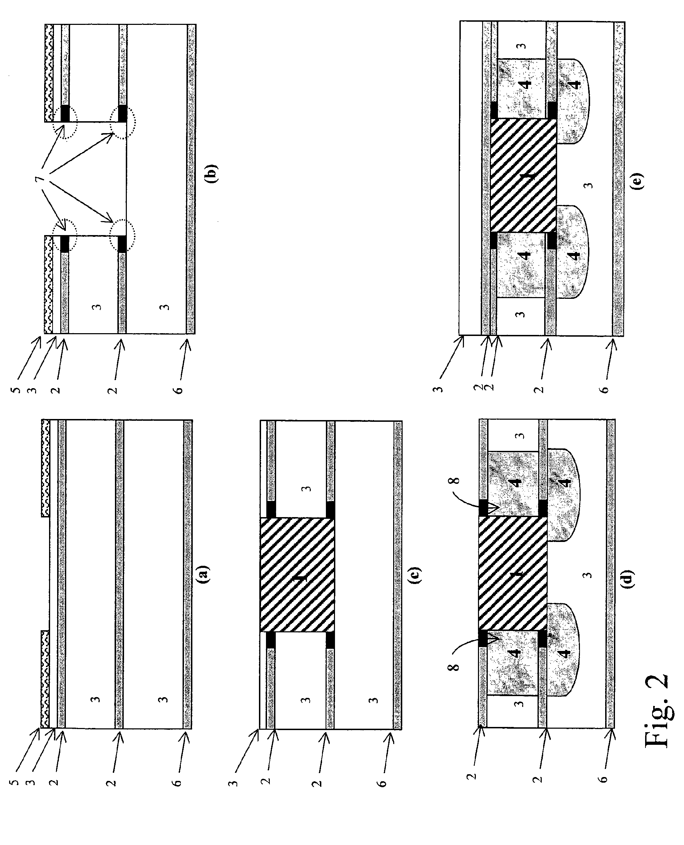

A preferred embodiment of the present invention (Fig.2) is as follows: the starting point of the process is a standard Cu single or dual damascene stack as described in Fig. 2a. The dry etch step takes place in an O₂ containing plasma, leading to local oxidation of the liner (i.e. SiC) (Fig. 2b). HF is typically used as etching agent. Fig. 2c shows the stack after barrier layer deposition (Ta/TaN (10/15 nm)), Cu seed layer deposition (100 nm), Cu electroplating (1 µm) and chemical mechanical polishing (CMP). Typical examples for barrier are TaN, Ta, TiN, Ti, WN, WCN etc. Currently employed methods for depositing a barrier are Plasma Enhanced Chemical Vapour Deposition (PECVD), Chemical Vapour Deposition (CVD), spin-on deposition etc. Fig. 2 (d) is after dielectric etching employing for instance vapour HF (VHF) (or any other compound etching the dielectric) (8) generating air cavities (4) near the dielectric / barrier interface. The range of SiC/SiO₂ conversion is in the nanometer range. This allows for diffusion of HF molecules to the underlying SiO₂ layers. The fact that this is a Ta(N)/SiC interface dependent process results in accelerated dissolution of SiO₂ laying between narrowly spaced Cu lines, compared to bare SiO₂ (existing between largely spaced Cu lines). The resulting stack is mechanically and chemically stable to allow further processing as depicted in Fig. 2e. In the latter figure a thick conformal layer, such as liner dielectric (2)/(3), has been deposited on top of the air cavities.

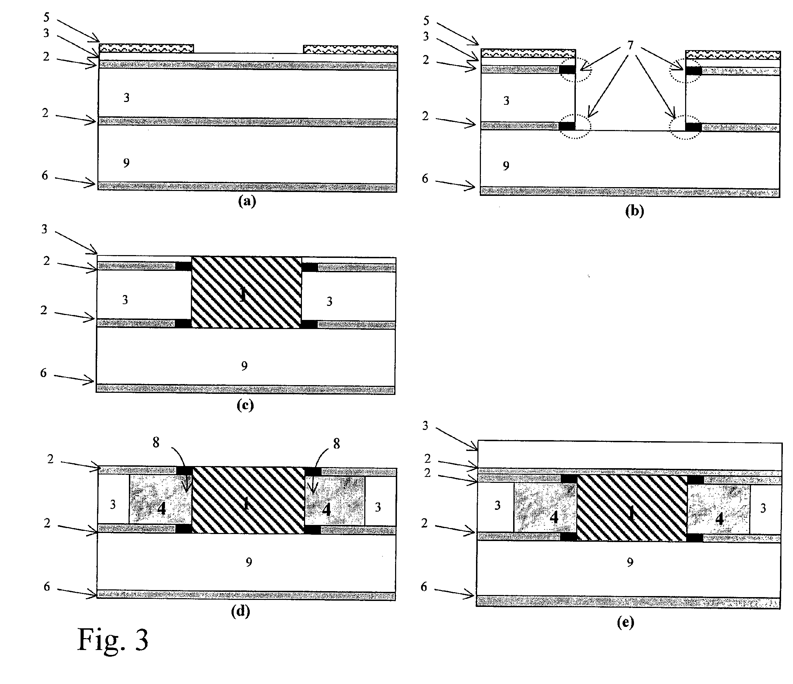

Another preferred embodiment of the present invention (FIG.3) is as follows:

As in the first embodiment, the starting point is a standard Cu single or dual damascene stack as described in Fig. 3a, with a difference being the presence of a HF resistant layer (9) (i.e. Chemically deposited SiOC) as a basis layer under the Cu lines. The dry etch step takes place in an O₂ containing plasma, leading to local oxidation of the liner (7) (i.e. SiC) (Fig. 3b). The resulting stack is mechanically and chemically stable to allow further processing as depicted in Fig. 3e. Note that no airgap is generated underneath the Cu lines allowing a better mechanical stability of the stack.

Another preferred embodiment of the present invention *(FIG. 4*) is as follows:
The starting point is a standard Cu single or dual damascene stack as described in Fig. 4a. The dry etch step takes place in an O₂ plasma (see Fig. 4b) generating plugs at the SiC/Ta(N) interface (Fig. 4b). After resist strip, a supplementary conformal CVD SiC liner (i.e. 50 nm) is deposited, covering the whole exposed surface (Fig. 4c). An isotropic O₂ plasma treatment is then applied in order to open the bottom SiC as shown in Fig. 4d. VHF will diffuse through the induced plugs to the adjacent SiO₂ material, while leaving the Cu lines embodied with SiC (Fig. 4e). The resulting stack is mechanically and chemically stable to withstand further processing (Fig. 4f).

When one considers the size of created airgaps (4) as a measure, the duration of the step of "chemically and/or mechanically changing the properties of the liner layers locally" is less critical, as compared to duration of the step "applying the etching substance to the stack of layers". Independent of the size of the area of the liner layers which is chemically and/or mechanically changed, the airgap size can be controlled by a controlled duration of the step of "applying the etching substance to the stack of layers".

The distance between neighbouring conductor lines is determined by the limitations of state-of-the-art techniques with respect to forming neighbouring holes in the stack of layers. Typically metal lines are spaced at about 1 *µm*. The present invention is a scaling invariant and is not limited to any distance between conductor lines, since the step of "chemically and/or mechanically changing the properties of the liner layers locally" can be applied on nanometer scale and smaller.

### Practical examples:

A 200 mm wafer consisted of a standard single-damascene (SD) stack including a 600 nm SiO₂ on a 50 nm SiC liner lying on top of a 500 nm SiO₂ supported on a 50 nm Si₃N₄ adhesion layer on a Si(100) as shown in Fig. 2a. After lithography, the stack was dry etched until opening of the SiC layer as shown in Fig. 2b. Subsequently a 25 nm Ta(N) diffusion barrier (10 nm Ta(N), 15 nm Ta) and a 100 nm Cu seed layer were deposited by self ionised plasma (SIP). The trenches were filled by Cu electroplating (Fig. 2c) and the remaining material removed by chemical mechanical polishing (see Fig. 2d).
Organosilicon trimethylsilane gas and He at a pressure of ca. 8 Torr were employed as precursors for a-SiC:H (amorphous hydrogenated SiC). For SiO₂, SiH₄ and N₂O at 2.6 Torr served as precursors. The main mechanical characteristic of a-SiC:H (also referred to as BLOK or barrier low-k) is a +40 to +300 MPa stress
The dry etch consisted according to the following conditions:
- Pressure range:175 and 70 mTorr (double step SiO₂ etch) and 90 mTorr (SiC etch).
- Temperature: chuck temperature is set at 20 degrees C; wafer temperature during dry etch sequence can ramp up to 70-80 degrees C depending on the process specifications and duration
- Species:
   * SiO₂ is etched in a 2-step sequence, including a main etch based on Ar, O₂, CF₄ and CHF₃ (low SiO₂/SiC selectivity) plus an additional overetch based on Ar, C₄F₈, O₂.
   * SiC is etched with a plasma composed on Ar, N₂, CF₄, CHF₃.
- Etch time: depends on the features size and depth, but typically takes ∼ 60s for etching a 250nm wide trench over a depth of 600nm (SiO₂ main etch step).
   The strip was done in two steps (i) dry strip which employed vapour H2O and (ii) wet strip.

Additionally, the samples underwent a well controlled SiO₂ etch by using a HF solution (49 % clean room compatible). The amount of etched SiO₂ can be easily controlled by the time and temperature employed. Fig. 7 is a plot of etch rate vs. VHF exposure and Fig. 8 shows the resulting incorporated airgaps. Fig. 8 is a schematic of a typical cross-sectioned SD stack after VHF exposure.

### TEM and EFTEM observations.

A typical cross-sectional TEM image of the SD stack is shown in Fig.5 at low (a) and high (b) resolution. The right side of the sample in Fig. 5a corresponds to the thinnest part of the wedge as evidenced by its lighter contrast. The spherical profile of the SiC layer in the vicinity of the SiC / Ta(N) interface visible by TEM and supported by EFTEM suggest that this layer has been locally converted to SiO₂ importantly decreasing its contact area with the Ta(N) barrier wall. This SiC / SiO₂ conversion is ascribed to the action of the oxygen containing plasma employed at the dry etch step.

### FIB, SEM and optical microscopy observations.

Fig.6a shows typical FIB cross-sectional images of and isolated Cu line as the surrounding SiO₂ is gradually dissolved after VHFexposure. Half of the upper SiO₂ layer is removed after 4 mn of etch as shown in Fig.6ai. As the HF exposure continues, the underlying SiO₂ film is progressively removed underneath the SiC / Ta(N) interface (leading to the incorporation of air under the metal structure). The afore-mentioned phenomenon proved to take place selectively for SiO₂ material lying beneath any SiC / Ta(N) interface. After prolonged HF etch times (more than ca. 8 mn) the stack modification can be easily monitored by optical inspection.

Fig. 9 is a schematic representing the SD stack after an arbitrary VHF exposure time leading to the incorporation of airgaps between narrowly spaced (300 mm) lines. This figure shows that deposition of new layers on top of the airgap structure is possible. Here (16) refers to a SiC (50 nm) - SiO2 (300 nm) - Si3N4 (500 nm) layer. This shows moreover that sacrificial layers, liner layers and if appriopriate, basis layers can be formed on top of the airgap structure, after which the embodiments of the present invention can be repeated.

The above description discloses several methods and materials of the present invention. This invention is susceptible to modifications in the methods and materials, as well as alterations in the fabrication methods and equipment. Such modifications will become apparent to those skilled in the art from a consideration of this disclosure or practice of the invention disclosed herein. Consequently, it is not intended that this invention be limited to the specific embodiments disclosed herein, but that it cover all modifications and alternatives coming within the true scope and spirit of the invention as embodied in the attached claims. All patents, applications, and other references cited herein are hereby incorporated by reference in their entirety.

## Claims

1. Method for the production of airgaps (4) in a semiconductor device, said semiconductor device comprising a stack of layers, said stack of layers comprising at least one iteration of a sub-stack of layers, said sub-stack of layers comprising;
- a liner layer (2) made of liner material;
- a sacrificial layer (3) made of sacrificial layer material under said liner layer (2);
wherein
- said liner material is resistant to a first etching substance;
- said first etching substance is able to etch said sacrificial layer material;
said method comprising the steps of
a) etching a hole in said stack of layers with a second etching substance,
b) chemically and/or mechanically changing the properties of said liner layers (2) locally, whereby part of said liner layers (2) is converted locally and becomes etchable by said first etching substance.
c) creating in said hole a line (1) made of a conductive material, optionally separated from said sacrificial layer (3) by a barrier layer, said line (1) or, if present, said barrier layer being resistant to said first etching substance;
d) applying said first etching substance to said stack of layers whereby airgaps (4) are created around said line (1).

2. method according to claim 1, whereby step (c) comprises the steps of:
i. optionally depositing a barrier layer.
ii. depositing on top of said barrier layer a layer of electrically conductive material.
iii. applying a subtractive technique on top of said stack of layers
whereby at least 1 embedded line is created.

3. method according to claim 1 to 2, whereby a protective layer is deposited on the exposed part of said line before step (d) is performed.

4. method according to claim 1 to 3, whereby said conductive material is selected from the group of [metals, carbon nanotubes, conducting polymers]

5. method according to claim 1 to 4, whereby said conductive material is Cu, Au or Ag.

6. Method according to claim 1 to 5, whereby said stack of layers further comprises a basis layer (9).

7. Method according to claim 1 or 6, whereby the steps of etching a hole in said stack of layers, and chemically and/or mechanically changing the properties of said liner layers locally, are performed at the same time.

8. Method according to claim 1 to 7, whereby said liner layer material is converted locally into said sacrificial material.

9. Method according to claim 1 to 8, wherein the chemically and/or mechanically changed part of said liner layers have in-plane dimensions smaller than 1 *µm*.

10. Method according to claim 9 wherein the chemically and/or mechanically changed part of said liner layers have in-plane dimensions smaller than 500 nm.

11. Method according to claim 10 wherein the chemically and/or mechanically changed part of said liner layers have in-plane dimensions smaller than 100 nm.

12. Method according to claim 11 wherein the chemically and/or mechanically changed part of said liner layers have in-plane dimensions smaller than 10 nm.

13. Method according to claim 1 to 12, wherein said stack of layers is a single or dual damascene stack.

14. Method according to claim 1 to 13, wherein said basis layer is resistant to said second etching substance.

15. Method according to claim 1 to 14, wherein said basis layer is resistant to said first etching substance.

16. Method according to claim 1 to 15, wherein said sacrificial layer material is silicon dioxide (SiO₂).

17. Method according to claim 1 to 16, wherein said liner layer material is silicon carbide (SiC).

18. Method according to claim 1 to 17, wherein said second etching substance comprises O₂.

19. Method according to claim 1 to 18, whereby said first etching substance comprises hydrofluoric acid (HF).

20. Method according to claim 1 to 19, wherein said hole is located at the back end of line.

21. Method according to claim 6 to 20, wherein said basis layer comprises an embedded metal line.

22. Method according to claim 6 to 21, wherein said embedded metal line and said metal line are forming an electrical contact.

23. Method for the production of airgaps (4) in a semiconductor device, by repeating the steps of
i. Applying the method according to claim 1 to 22 on a stack of layers as described in any of the beforementioned claims.
ii. Creating a next stack of layers as described in any of the beforementioned claims on top of the airgap structure resulting from step (i).
